# EUROPÄISCHE PATENTSCHRIFT

(11) **EP 3 583 248 B1**
(45) Veröffentlichungstag und Bekanntmachung des Hinweises auf die Patenterteilung: **24.06.2020**
(21) Anmeldenummer: 18705595.9
(22) Anmeldetag: 13.02.2018
(51) Int. Cl.: C30B 13/20, C30B 13/28, C30B 13/30, C30B 13/32, C30B 29/06

(54) **VERFAHREN ZUM ZIEHEN EINES EINKRISTALLS NACH DEM FZ-VERFAHREN**
METHOD FOR PULLING A MONOCRYSTAL IN ACCORDANCE WITH THE FZ METHOD
PROCÉDÉ DE TIRAGE D'UN MONOCRISTAL SELON LE PROCÉDÉ DE LA ZONE FLOTTANTE

(30) Priorität: 15.02.2017 DE 102017202413
(43) Veröffentlichungstag der Anmeldung: 25.12.2019
(73) Patentinhaber: Siltronic AG, 81737 München (DE)
(72) Erfinder: SCHRÖCK, Thomas, 84556 Kastl (DE)
(74) Vertreter: Staudacher, Wolfgang
(86) Internationale Anmeldenummer: PCT/EP2018/053479
(87) Internationale Veröffentlichungsnummer: WO 2018/149797

(56) Entgegenhaltungen:
- JP-A- H11 189 486
- JP-A- 2000 044 380
- JP-A- 2010 076 979

## Beschreibung

Die vorliegende Erfindung betrifft ein Verfahren zum Ziehen eines Einkristalls nach dem FZ-Verfahren, bei dem ein Polykristall mittels einer elektromagnetischen Schmelzvorrichtung aufgeschmolzen und anschließend wieder auskristallisiert wird, sowie eine entsprechende Anlage.

### Stand der Technik

Beim Ziehen von Einkristallen, insbesondere aus Halbleitermaterial, nach dem FZ-Verfahren, dem sogenannten Floating-Zone-Verfahren bzw. Zonenziehverfahren, können sehr reine Einkristalle erzeugt werden. Hierbei wird ein Polykristall, also insbesondere ein Kristall aus polykristallinem Halbleitermaterial, aufgeschmolzen und anschließend wieder auskristallisiert.

Bei einem solchen Verfahren können verschiedene Phasen unterschieden werden, wie sie beispielsweise in WO 2014/033212 A1 beschrieben werden. Der Polykristall wird hierbei zunächst aufgeschmolzen und dann an einem einkristallinen Impfling wieder auskristallisiert.

Dabei wird der Durchmesser des zu fertigenden Einkristalls von zunächst in etwa dem Durchmesser des Impflings in einem sog. Dünnhals-Abschnitt verkleinert und anschließend in einem konischen Abschnitt bis zu einem gewünschten Durchmesser geweitet. Dann kann der Durchmesser konstant gehalten werden, um beispielsweise einen stabförmigen Einkristall zu erhalten.

2010076979 A offenbart ein Verfahren zum Ziehen eines Einkristalls nach dem FZ Verfahren, bei dem zu Beginn der Phase zur Bildung des konischen Abschnitts der Durchmesser der Kristallisationsgrenzfläche mittels Triangulation und unter Verwendung zweier Kameras berechnet wird, um eine automatisierte Prozesskontrolle zu ermöglichen.

JP H11189486 A offenbart ein Verfahren zum Ziehen eines Einkristalls nach dem FZ Verfahren, bei dem zur automatisierten Prozesskontrolle beide Kristallisationsgrenzflächen und die Form der Schmelzzone mittels einer Kamera erfasst und ausgewertet werden.

Aus der JP 4 016 363 B2 ist beispielsweise ein FZ-Verfahren bekannt, bei dem unter Verwendung vier verschiedener Kameras verschiedene Bereiche des Polykristalls, des daran angebrachten Impflings sowie des dazwischen befindlichen flüssigen bzw. geschmolzenen Materials aufgenommen werden. Daraus wird dann neben Durchmessern des Polykristalls bzw. des Einkristalls eine Höhe des Bereichs bzw. der Zone des flüssigen bzw. geschmolzenen Materials, die sog. Zonenhöhe, ermittelt.

Bei einem solchen Verfahren kann ein Abstand zwischen einer unteren Kante am äußeren Rand des Polykristalls und einer unteren Phasengrenze zwischen flüssigem Material und festem Material auf Seiten des Impflings ermittelt werden. Basierend darauf können verschiedene Regelungen vorgenommen werden.

In einer Phase, in welcher der konische Abschnitt des Polykristalls aufgeschmolzen werden soll, ist in der Regel eine (mitunter drastische) Reduzierung der Geschwindigkeit, mit welcher der Polykristall relativ zur Schmelzvorrichtung bewegt wird, nötig. Damit kann erreicht werden, dass die nötige Menge an Material aufgeschmolzen wird. Unter Verwendung eines Abstands, wie zuvor erwähnt, lässt sich eine Position des Polykristalls, bei welcher die Reduzierung der Geschwindigkeit erfolgen soll, jedoch nicht oder nur schwierig ermitteln.

Vor diesem Hintergrund stellt sich daher die Aufgabe, eine einfachere und/oder genauere Möglichkeit zum Einstellen einer Position des Polykristalls, bei der dessen Geschwindigkeit reduziert werden soll, zur Verfügung zu stellen, um so insbesondere eine Automatisierung des Prozesses zu ermöglichen.

### Offenbarung der Erfindung

Erfindungsgemäß wird ein Verfahren zum Ziehen eines Einkristalls mit den Merkmalen des unabhängigen Patentanspruchs 1 vorgeschlagen.

Vorteilhafte Ausgestaltungen sind Gegenstand der Unteransprüche sowie der nachfolgenden Beschreibung.

Die Erfindung geht aus von einem Verfahren zum Ziehen eines Einkristalls nach dem FZ-Verfahren, bei dem ein Polykristall mittels einer elektromagnetischen Schmelzvorrichtung aufgeschmolzen und anschließend wieder auskristallisiert wird.

Als Material für den Polykristall und damit auch den zu fertigenden Einkristall kommt hier insbesondere ein Halbleitermaterial, bevorzugt Silizium, in Frage. Es versteht sich, dass das Material auch gewisse Unreinheiten oder Dotierungen enthalten kann.

In einer ersten Phase wird der Polykristall, der in aller Regel stabförmig mit einem Durchmesser von beispielsweise 160 mm ausgebildet ist, zunächst mittels einer Schmelzvorrichtung, beginnend an einem (in Bezug zur Schwerkraft bei vertikaler Anordnung des stabförmigen Polykristalls) unteren Ende, aufgeschmolzen. Als Schmelzvorrichtung kommt hier insbesondere ein Induktor bzw. eine Induktionsspule in Betracht. Hierbei kann durch Anregung mittels Hochfrequenz elektromagnetische Energie in den Polykristall, der in die Nähe des Induktors gebracht wird, eingekoppelt werden.

In der erwähnten ersten Phase kann der Polykristall, der an seinem unteren Ende in aller Regel konisch ausgebildet ist, ggf. mit einem flachen unteren Abschnitt, abgesenkt und an ein mittiges Loch im Induktor herangeführt werden. Um möglichst viel elektromagnetische Energie in den Polykristall einzukoppeln, ist es zweckmäßig, das untere Ende des Polykristalls an den Rand des Lochs zu bringen. Der Polykristall beginnt dann am unteren Ende zu schmelzen, wobei sich zunächst ein Tropfen flüssigen Materials bildet, der am Polykristall hängt.

In einer zweiten Phase wird nun ein einkristalliner Impfling, der insbesondere ebenfalls stabförmig ausgebildet ist und einen Durchmesser von beispielsweise ca. 4 bis 7 mm aufweist, an das untere Ende des Polykristalls und damit an den Tropfen flüssigen Materials, angebracht und dann beginnend von einem oberen Ende des Impflings an aufgeschmolzen. Das Aufschmelzen des Impflings beginnt dabei in der Regel erst, nachdem sich die Temperatur des Impflings an diejenige des bereits flüssigen Materials angeglichen hat. Der Impfling kann zweckmäßigerweise über einen gewissen Bereich seiner Länge, die beispielsweise zwischen 5 und 20 mm liegen kann, aufgeschmolzen werden. Es versteht sich jedoch, dass ein gewisser Bereich an seinem unteren Ende nicht aufgeschmolzen wird, da dieser zur Befestigung in einer Ziehvorrichtung benötigt wird. Zum Aufschmelzen des Impflings werden der Impfling und der Polykristall nach oben bewegt. Dies bedeutet beispielsweise, dass der Impfling in Richtung des Lochs des Induktors bewegt wird. Dabei wird ein Vorimpfling an dem unteren Ende des Polykristalls gebildet. Unter einem Vorimpfling ist dabei ein Bereich, insbesondere in Form eines Zapfens, am unteren Ende des Polykristalls zu verstehen, an dem dann der Impfling angebracht ist.

In einer dritten Phase wird nun zwischen einem unteren Abschnitt des Impflings (an dem dieser beispielsweise in der erwähnten Ziehvorrichtung gehalten werden kann) und dem Polykristall (also dem noch festen und noch nicht geschmolzenen Anteil des Polykristalls) ein Dünnhals-Abschnitt gebildet, dessen Durchmesser geringer als derjenige des Impflings ist. Dieser Dünnhals-Abschnitt wird gebildet, um etwaige Versetzungen, die sich beispielsweise durch das Anbringen des Impflings an das flüssige Material am Polykristall, bilden, zu entfernen. Der Durchmesser des Dünnhals-Abschnitts kann dabei beispielsweise zwischen 2 und 4 mm betragen. Zur Ausbildung dieses Dünnhals-Abschnitts können der Impfling und der Polykristall, nachdem der Impfling wie gewünscht aufgeschmolzen ist, wieder nach unten bewegt werden. Indem nun die Absenkgeschwindigkeit des Impflings erhöht wird, nimmt der Durchmesser der Zone flüssigen Materials bzw. des dann auskristallisierenden Materials aufgrund der Massenerhaltung ab.

Nach dem Dünnhals-Abschnitt kann dann der Durchmesser des Einkristalls bis zu einem gewünschten Durchmesser von beispielsweise ca. 200 mm erhöht und dann beibehalten werden.

Hierzu kann in einer vierten Phase beim FZ-Verfahren nun zwischen dem Dünnhals-Abschnitt und dem Polykristall ein konischer Abschnitt gebildet werden. Ein solcher konischer Abschnitt dient dazu, den Durchmesser von demjenigen des Dünnhals-Abschnitts auf einen gewünschten Durchmesser zu weiten. Hierzu ist nun in aller Regel nötig, dass eine Absenkgeschwindigkeit des Impflings (zusammen mit dem bereits daran auskristallisierten Material) und des Polykristalls verändert werden, um den Durchmesser zu erhöhen. Insbesondere führt eine Reduzierung der Absenkgeschwindigkeit dazu, dass mehr Material auskristallisieren kann, wodurch der Durchmesser erhöht wird. Insbesondere kann in dieser vierten Phase der Polykristall zunächst mit mittlerer Geschwindigkeit, dann mit erhöhter Geschwindigkeit und anschließend mit sehr geringer Geschwindigkeit bewegt bzw. abgesenkt werden. Solche unterschiedlichen Geschwindigkeiten sind nötig, um möglichst schnell über eine Phase, in welcher die Phasengrenze nicht gleichmäßig vorhanden ist, überwunden wird. Insbesondere die Reduzierung der Geschwindigkeit (auf die erwähnte sehr geringe Geschwindigkeit) dient dazu, dass genügend Material des Polykristalls kontinuierlich aufgeschmolzen werden kann, da dies auch für den sich vergrößernden Durchmesser des konischen Abschnitts nötig ist. Eine Reduzierung kann beispielsweise von einer Geschwindigkeit von 0,5 mm/min oder mehr, insbesondere zwischen 0,5 und 1 mm/min, auf eine Geschwindigkeit von weniger als 0,5 mm/min, insbesondere zwischen 0,1 und 0,5 mm/min, erfolgen. Vor und nach der Reduzierung der Geschwindigkeit kann der Polykristall jedoch insbesondere entsprechend einer Soll-Kurve für die Geschwindigkeit bewegt werden.

Erfindungsgemäß wird nun vor Erreichen der vierten Phase eine Umschalte-Position des Polykristalls, bei welcher eine Geschwindigkeit, mit welcher der Polykristall relativ zur Schmelzvorrichtung bewegt wird, betragsmäßig reduziert werden soll, ermittelt. In der vierten Phase wird dann die Geschwindigkeit, mit welcher der Polykristall relativ zur Schmelzvorrichtung bewegt wird, bei Erreichen der Umschalte-Position betragsmäßig entsprechend reduziert.

Am unteren Ende des Polykristalls ist üblicherweise ein sog. Zapfen ausgebildet. Bei einem neuen Polykristall weist dieser Zapfen in der Regel eine ebene Fläche auf. Wenn der verwendete Polykristall jedoch bereits angeschmolzen wurde, beispielsweise bei einem FZ-Verfahren, das - aus welchen Gründen auch immer - abgebrochen werden musste, so weist der Zapfen (der dann insbesondere bei dem abgebrochenen Verfahren als Vorimpfling ausgebildet wurde) keine definierte Form mehr auf. Insbesondere kann diese Form auch von der Schmelzvorrichtung, die bei dem abgebrochenen FZ-Verfahren verwendet wurde, abhängen. Damit kann also die Form des Zapfens bzw. dessen Position der Basis am konischen Abschnitt von Polykristall zu Polykristall variieren. Dementsprechend kann auch die Umschalte-Position von Polykristall zu Polykristall variieren.

Indem nun also bereits in einer frühen Phase des FZ-Verfahrens, insbesondere bereits in der ersten Phase, die entsprechende Umschalte-Position ermittelt wird, kann in der vierten Phase, also insbesondere dann, wenn das Umschalten nötig ist, sehr einfach die Geschwindigkeit reduziert werden. Dies ermöglicht also eine Steuerung der Geschwindigkeit, mit welcher der Polykristall bewegt wird. Eine Regelung ist nicht erforderlich. Insbesondere wird damit eine Automatisierung des Verfahrens deutlich erleichtert.

Zur Ermittlung der Umschalte-Position wird ein Abstand einer für den Polykristall charakteristischen Stelle, die sich am unteren Ende eines konischen Abschnitts des Polykristalls befindet, relativ zu einem fixen Bezugspunkt, beispielsweise einer bestimmten Stelle an der Schmelzvorrichtung, gemessen, wobei aus dem Abstand dann die Umschalte-Position ermittelt wird. Diese charakteristische Stelle kann dabei insbesondere eine solche Stelle umfassen, an welcher sich ein Neigungswinkel des konischen Abschnitts des Polykristalls um mehr als einen vorbestimmten Wert ändert. Hierunter fällt also insbesondere der sog. Zapfen am unteren Ende des Polykristalls. Eine solche Stelle kann dabei beispielsweise anhand eines charakteristischen oder vorbestimmten Durchmessers des Polykristalls erkannt werden. Der Abstand ist hier also zuvor nicht bekannt und wird, mit geeigneten Mittel, beispielsweise im Rahmen einer Bildverarbeitung, erst gemessen.

Zu diesem Abstand kann, insbesondere zeitgleich, eine Zwischen-Position des Polykristalls, insbesondere relativ zur der Schmelzvorrichtung, beispielsweise anhand einer aktuellen Stellung einer Absenk-bzw. Ziehvorrichtung, ermittelt werden. Bei der Zwischen-Position kann es sich also um eine einfach messbare oder ausgebbare Position des Polykristalls (insbesondere in vertikaler Richtung) handeln. Unter Verwendung eines gewünschten Abstands der charakteristischen Stelle zu der Schmelzvorrichtung, bei dem die Geschwindigkeit reduziert werden soll, also insbesondere einem möglichst idealen Abstand, bei dem genau die richtige Menge an Material aufgeschmolzen wird, wenn dort die Geschwindigkeit entsprechend reduziert wird, kann also - beispielsweise durch Addition oder Subtraktion (je nach Situation) eines geeigneten Wertes - aus der zuvor ermittelten Zwischen-Position des Polykristalls die Umschalte-Position ermittelt werden, beispielsweise dann ebenfalls als eine bestimmte Stellung der Absenk-bzw. Ziehvorrichtung. Damit kann also eine zuvor nicht bekannte Position der charakteristischen Stelle in Bezug zu dem gesamten Polykristall ermittelt werden, und es kann während der vierten Phase sehr einfach die Reduzierung der Geschwindigkeit erfolgen.

Alternativ wird zur Ermittlung der Umschalte-Position eine Zwischen-Position des Polykristalls ermittelt, bei welcher die für den Polykristall charakteristische Stelle, die sich am unteren Ende eines konischen Abschnitts des Polykristalls befindet, während einer Bewegung des Polykristalls einen vorgegebenen Abstand zu einem fixen Bezugspunkt erreicht oder überschreitet, wobei aus der Zwischen-Position die Umschalte-Position ermittelt wird. Auch hier kann die charakteristische Stelle insbesondere anhand eines charakteristischen oder vorbestimmten Durchmessers des Polykristalls erkannt werden. Wenn nun beispielsweise beim Hochziehen oder Absenken des Polykristalls kontinuierlich oder wiederholt der Durchmesser bei dem vorgegeben Abstand entsprechend erfasst wird, so kann die Zwischen-Position des Polykristalls, insbesondere relativ zur der Schmelzvorrichtung, beispielsweise dann ebenfalls als eine bestimmte Stellung der Absenk-bzw. Ziehvorrichtung, ermittelt werden, wenn die charakteristische Stelle den vorgegebenen Abstand erreicht oder überschreitet. Dies kann beispielsweise dadurch erkannt werden, dass der Durchmesser auf Höhe des vorgegebenen Abstands einen bestimmten Wert unterschreitet oder überschreitet. Durch Addition des entsprechenden Abstands, also hier des erwähnten vorgegebenen Abstands vom fixen Bezugspunkt korrigiert um den gewünschten Abstand der Stelle vom fixen Bezugspunkt zum Zeitpunkt, zudem die Geschwindigkeit reduziert werden soll, kann also sehr einfach die Umschalte-Position ermittelt werden.

Bei beiden Varianten kann also die Zwischen-Position ermittelt werden, anhand welcher die Umschalte-Position ermittelt werden kann. Während bei der ersten Variante der Abstand der charakteristischen Stelle zu dem Bezugspunkt (beispielsweise zu einem geeigneten Zeitpunkt) einfach gemessen wird, so wird bei der zweiten Variante gewissermaßen der Abstand von dem Bezugspunkt vorgegeben und dieser Abstand wird dann überwacht, bis die charakteristische Stelle während einer Bewegung des Polykristalls diesen Abstand erreicht bzw. passiert. Je nach Gegebenheiten kann die eine oder die andere Variante einfacher bzw. vorteilhafter sein.

Vorzugsweise wird die für den Polykristall charakteristische Stelle unter Verwendung einer Kamera, die insbesondere oberhalb der Schmelzvorrichtung angeordnet ist, erfasst. Damit ist eine besonders einfache Erfassung bzw. Ermittlung des Abstandes möglich. Beispielsweise können mittels einer Kamera Hell-Dunkel-Unterschiede bzw. Hell-Dunkel-Übergänge sehr gut erkannt werden, wodurch auch eine Änderung des Neigungswinkels, wodurch sich die Reflexion auf dem Kristall ändert, gut erfasst werden kann.

Vorteilhafterweise wird die Umschalte-Position in der ersten Phase und/oder in der zweiten Phase, also beispielsweise auch während eines Übergangs von der ersten zur zweiten Phase, ermittelt. Hier kann die Umschalte-Position besonders gut ermittelt werden, da beispielsweise mittels einer Kamera eine gute Sicht auf die erwähnte Stelle zur Ermittlung des Durchmessers möglich ist.

Offenbart ist weiterhin eine Anlage, die zur Durchführung des erfindungsgemäßen Verfahrens eingerichtet ist. Die Anlage kann hierzu insbesondere eine Schmelzvorrichtung, wie sie beispielsweise bereits mehrfach erwähnt wurde, sowie auch eine geeignete Recheneinheit aufweisen. Die Recheneinheit kann dann entsprechen eingerichtet sein, die einzelnen Verfahrensschritte durchzuführen und beispielsweise auch, die Kameras entsprechend anzusteuern und deren Bilder auszuwerten.

Zur Vermeidung von Wiederholungen sei im Übrigen hinsichtlich weiterer Ausgestaltungen auf obige Erläuterungen zum erfindungsgemäßen Verfahren verwiesen.

Weitere Vorteile und Ausgestaltungen der Erfindung ergeben sich aus der Beschreibung und der beiliegenden Zeichnung.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

Figur 1a zeigt schematisch einen Polykristall und eine Schmelzvorrichtung, womit ein erfindungsgemäßes Verfahren durchführbar ist.
Figur 1b zeigt die Schmelzvorrichtung aus Figur 1 in einer anderen Ansicht.
Figur 2 zeigt verschiedene Formen des unteren Endes eines Polykristalls.
Figuren 3a bis 3g zeigen schematisch verschiedene Phasen eines erfindungsgemäßen Verfahrens in einer bevorzugten Ausführungsform.
Figur 4 zeigt einen zeitlichen Ablauf eines erfindungsgemäßen Verfahrens in einer bevorzugten Ausführungsform.

### Ausführungsform der Erfindung

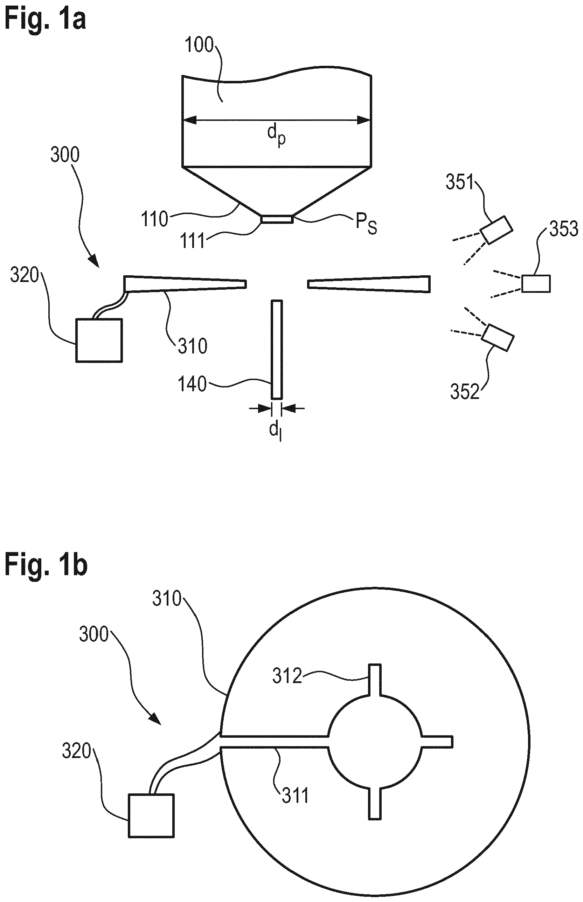

In Figur 1a sind schematisch ein Polykristall 100 und eine Schmelzvorrichtung 300, womit ein erfindungsgemäßes Verfahren durchführbar ist, in Seitenansicht dargestellt. Die Schmelzvorrichtung 300 weist hier einen Induktor bzw. eine Induktionsspule 310 auf, die mittels einer Ansteuereinheit 320, die über entsprechende Leitungen angeschlossen ist, beispielsweise mit Hochfrequenz entsprechend angesteuert bzw. betrieben werden kann.

Die Schmelzvorrichtung 300 kann dabei Teil einer Anlage, die zum Ziehen eines Einkristalls eingerichtet ist, sein. Eine solche Anlage kann dann zudem entsprechende Halteeinrichtungen für den Induktor 300, den Einkristall 100 sowie die Kameras 351, 352 und 353 aufweisen. Weiterhin kann eine solche Anlage eine Recheneinheit (nicht dargestellt) zum Steuern der übrigen Bestandteile aufweisen.

Der Polykristall 100, der insbesondere Silizium aufweisen oder aus diesem bestehen kann, ist überwiegend stabförmig oder zylinderförmig ausgebildet. Im stab- bzw. zylinderförmigen Bereich, von dem hier nur ein Teil dargestellt ist, hat der Polykristall 100 einen Durchmesser dp, der beispielsweise 160 mm betragen kann. An seinem unteren Ende ist der Polykristall 100 jedoch konisch ausgebildet, d.h. erweist einen konischen Abschnitt 110 auf. Weiterhin ist zu sehen, dass der konische Abschnitt 110 wiederum einen sog. Zapfen 111, hier mit einem flachen Ende, an seinem unteren Ende aufweisen kann.

Weiterhin ist ein Impfling 140 mit einem Durchmesser dₗ, der beispielsweise 4 bis 7 mm betragen kann, zu sehen. Bei dem Impfling handelt es sich um einen Einkristall, der ebenfalls stab- bzw. zylinderförmig ausgebildet sein kann.

In Figur 1b ist die Schmelzvorrichtung 300 aus Figur 1a in einer anderen Ansicht, hier einer Draufsicht, dargestellt, allerdings ohne den Polykristall 100. Hier ist nun deutlich eine Ausnehmung bzw. ein Loch in der Mitte des Induktors 310 zu sehen, durch welches der Polykristall - während des Schmelzvorgangs und dann in verflüssigtem Zustand - hindurch geführt wird.

Insbesondere sind hier nun ein Hauptschlitz 311 sowie drei Nebenschlitze 312 zu sehen, die für die Funktion der Schmelzvorrichtung, insbesondere zur Erzeugung der elektromagnetischen Energie, von Vorteil sind. Wie zu sehen ist, ist der Induktor aufgrund des Hauptschlitzes 311 nicht geschlossen.

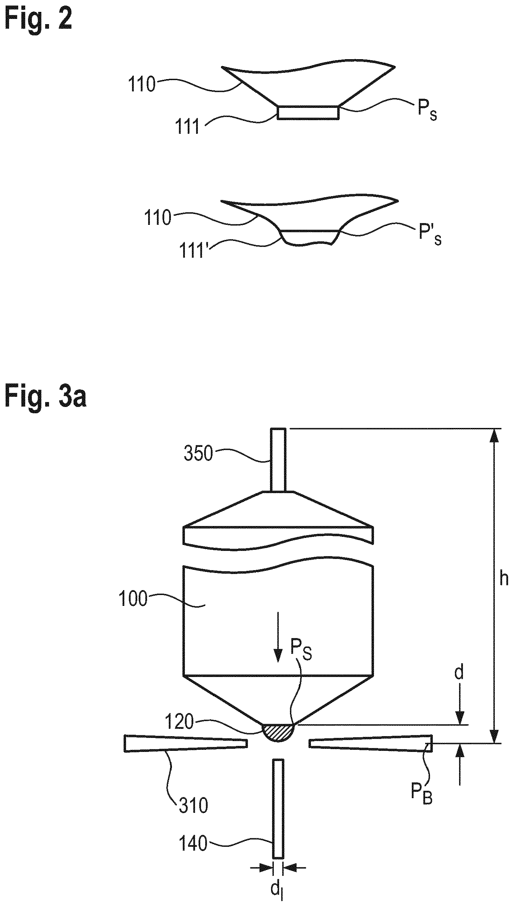

In Figur 2 ist das untere Ende des Polykristalls 100 aus Figur 1a mit dem konischen Abschnitt 110 und dem Zapfen 111 erneut dargestellt (oben). Zusätzlich ist zum Vergleich ein unteres Ende bzw. ein konischer Abschnitt eines Polykristalls dargestellt (unten), der nicht mechanisch bearbeitet wurde, sondern beispielsweise aus einem - nicht zu Ende geführten - Schmelzvorgang stammt. Wie zu sehen ist, sind der konische Abschnitt und der Zapfen 111' hier etwas anders geformt.

Diese andere Form kommt durch das Aufschmelzen und wieder Erstarren zustande. Insbesondere kann dabei die Basis P_{S} des Zapfens an eine für den Polykristall charakteristische Stelle verschoben sein. Ein bestimmter Abstand genau dieser Stelle bzw. Basis P_{S} zu der Schmelzvorrichtung 300 sollte jedoch eingehalten werden, wenn die Geschwindigkeit des Polykristalls reduziert wird, um einen möglichst guten Übergang zum konischen Abschnitt, der geformt werden soll, zu erreichen.

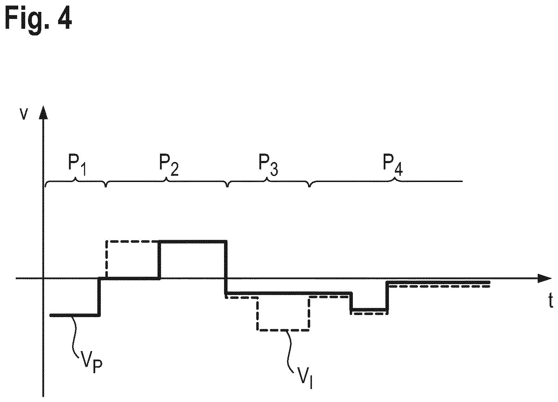

In den Figuren 3a bis 3g sind nun schematisch verschiedene Phasen eines erfindungsgemäßen Verfahrens in einer bevorzugten Ausführungsform dargestellt. Der Ablauf des Verfahrens soll im Folgenden anhand der Figuren 3a bis 3g sowie der Figur 4, die die Geschwindigkeiten v_{P} des Polykristalls und v_{I} des Impflings in den einzelnen Phasen über der Zeit t zeigt, näher erläutert werden.

In einer ersten Phase P₁ wird der Polykristall 100 zunächst an den Induktor 310 bzw. die Ausnehmung in dessen Mitte herangeführt. Hierzu wird der Polykristall beispielsweise mit einer konstanten Geschwindigkeit abgesenkt. Der Impfling 140 muss hierbei noch nicht bewegt werden. Entgegen der hier gezeigten Ausrichtung kann der Polykristall 100 auch näher an einen inneren Rand des Induktors 310 herangeführt werden, um eine bessere Einkopplung der elektromagnetischen Energie in den Polykristall 100 zu ermöglichen.

Der Polykristall 100 beginnt damit an seinem unteren Ende, also auch dem unteren Ende des konischen Abschnitts, aufzuschmelzen. Hierbei bildet sich ein Tropfen 120 flüssigen Materials, der am Polykristall hängt, wie in Figur 3a zu sehen ist. Hier und in den folgenden Figuren ist flüssiges Material schraffiert dargestellt, während festes Material weiß bzw. ohne Schraffur dargestellt ist.

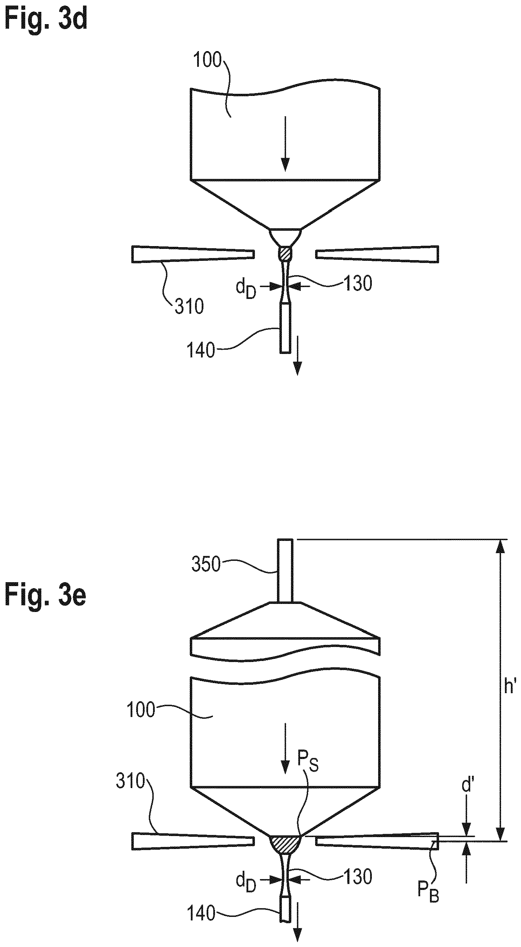

In dieser ersten Phase P₁ kann nun eine Umschalte-Position des Polykristalls 100, bei welcher eine Geschwindigkeit, mit welcher der Polykristall 100 relativ zur Schmelzvorrichtung 300 bewegt wird, reduziert werden soll, ermittelt werden. Hinsichtlich der Umschalte-Position sei an dieser Stelle auch auf Figur 3e verwiesen.

Hierzu wird in dem gezeigten Beispiel ein Abstand d einer für den Polykristall charakteristischen Stelle P_{S} am unteren Ende des konischen Abschnitts des Polykristalls 100, hier die Basis des (angeschmolzenen) Zapfens und damit des Tropfens 120 relativ zu einem fixen Bezugspunkt P_{B}, der hier beispielhaft einer bestimmten Stelle an dem Induktor 310 entspricht, gemessen. Hierzu kann eine der Kameras, wie sie in Figur 1a gezeigt sind, insbesondere die Kamera 351 oder 353, verwendet werden. Die Stelle P_{S} kann dabei insbesondere an ihrem charakteristischen Durchmesser erkannt werden.

Weiterhin wird eine Zwischen-Position des Polykristalls 100 relativ zur der Schmelzvorrichtung 300 ermittelt. Im gezeigten Beispiel entspricht diese Zwischen-Position dem Abstand h einer bestimmten Stellung einer Absenk-bzw. Ziehvorrichtung 350, mittels welcher der Polykristall 100 bewegt werden kann, zum fixen Bezugspunkt P_{B}. Es versteht sich, dass ein solcher Abstand h auch zu einem beliebigen anderen Bezugspunkt ermittelt werden kann. Insbesondere sei erwähnt, dass in aller Regel von der Absenk-bzw. Ziehvorrichtung 350 selbst eine aktuelle Position des Polykristalls (in Bezug zu der fest installierten Absenk- bzw. Ziehvorrichtung) ausgebbar ist.

Aus dieser Zwischen-Position bzw. diesem Abstand h kann nun die Umschalte-Position h' ermittelt werden, bei der dann beispielsweise die Stelle P_{S} einen bestimmten Abstand d' vom fixen Bezugspunkt P_{B} aufweist. Wie an der Figur 3a zu sehen ist, kann eine solche Umschalte-Position sehr einfach aus der Position bzw. dem Abstand h ermittelt werden.

Anstatt den Abstand d zu messen, ist es auch möglich - wie bereits eingangs erwähnt - den Abstand d vorher festzulegen und dann diesen festgelegten Abstand zu überwachen, bis die Stelle P_{S} diesen Abstand erreicht bzw. passiert. Es versteht sich, dass in der Figur nur der Übersichtlichkeit halber beide Abstände, d.h. der zu der Stelle ermittelte und der vorgegebene und überwachte, identisch sind.

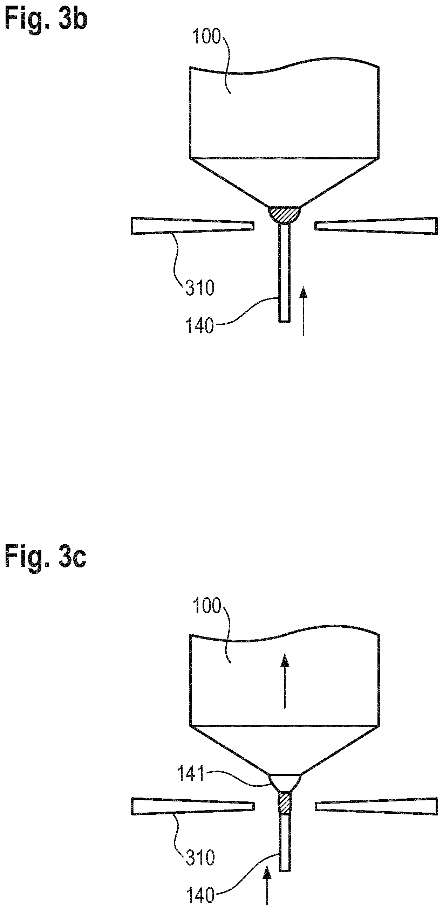

In einer zweiten Phase P₂ wird nun der Impfling 140 an das untere Ende des Polykristalls 100 und damit an den Tropfen 120 flüssigen Materials, angebracht, wie in Figur 3b zu sehen, und beginnend von einem oberen Ende des Impflings 140 aufgeschmolzen. Hierzu wird der Impfling zunächst beispielsweise mit einer bestimmten Geschwindigkeit auf den Polykristall 100 zu, also nach oben, bewegt, während sich der Polykristall 100 in Ruhe befinden kann. Das Aufschmelzen des Impflings 140 beginnt dabei in der Regel erst, nachdem sich die Temperatur des Impflings 140 an diejenige des bereits flüssigen Materials angeglichen hat.

Nachdem nun der Impfling 140 an dem Tropfen flüssigen Materials am unteren Ende des Polykristalls 100 angebracht und damit verschmolzen ist, werden der Polykristall 100 und der Impfling 140 gemeinsam nach oben bewegt, wie in Figur 3c zu sehen. Dabei wird auch der Vorimpfling 141 an dem unteren Ende des Polykristalls 100 gebildet. Der Impfling kann dann über einen gewissen Bereich seiner Länge, beispielsweise zwischen 5 und 20 mm, aufgeschmolzen werden, indem der Impfling in Richtung des Lochs des Induktors 310 bewegt wird.

Es versteht sich jedoch, dass ein gewisser Bereich an dem unteren Ende des Impflings 140 nicht aufgeschmolzen wird, da dieser Abschnitt zur Befestigung in einer Ziehvorrichtung (als Teil der erwähnten Anlage) benötigt wird.

In einer dritten Phase P₃ wird nun zwischen einem unteren Abschnitt des Impflings 140 und dem Polykristall 100 (also dem noch festen und noch nicht geschmolzenen Anteil des Polykristalls) ein Dünnhals-Abschnitt gebildet, dessen Durchmesser d_{D} mit beispielsweise 2 bis 4 mm geringer als derjenige des Impflings 140 ist. Hierzu werden der Polykristall 100 und der Impfling 140 zunächst zugleich, d.h. mit gleicher Geschwindigkeit, nach unten bewegt.

Die Absenkgeschwindigkeit des Impflings 140 wird nun zu einem gewissen Zeitpunkt gegenüber derjenigen des Polykristalls 100 erhöht. Damit nimmt der Durchmesser der Zone flüssigen Materials bzw. des dann auskristallisierenden Materials aufgrund der Massenerhaltung ab. In Figur 3d ist beispielsweise bereits ein Dünnhals-Abschnitt mit einer gewissen Länge gebildet.

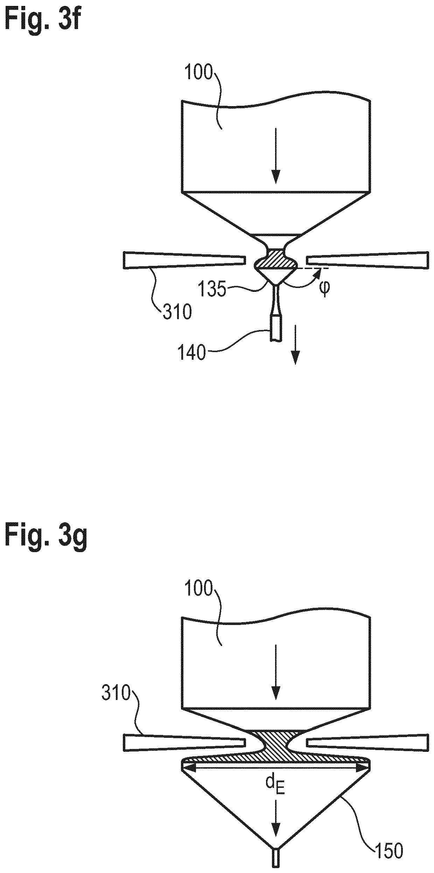

In einer vierten Phase P₄ kann nun zwischen dem Dünnhals-Abschnitt und dem Polykristall 100 ein konischer Abschnitt 135 gebildet werden, wie in den Figuren 3e und 3f zu sehen ist. Ein solcher konischer Abschnitt 135 dient dazu, den Durchmesser von demjenigen des Dünnhals-Abschnitts auf einen gewünschten Durchmesser d_{E} von beispielsweise 200 mm des zu fertigenden Einkristalls 150 zu weiten, wie in Figur 3g zu sehen ist. Der konische Abschnitt weist dabei einen Neigungswinkel ϕ auf.

Zur Bildung des konischen Abschnitts 135, also mit Beginn der Vergrößerung des Durchmessers, ist eine betragsmäßige Reduktion der Geschwindigkeit, mit welcher der Polykristall 100 relativ zur Schmelzvorrichtung 300 bewegt bzw. abgesenkt wird, nötig, um die entsprechende Menge an Material aufschmelzen zu können. In Figur 4 ist dies an der letzten gezeigten Geschwindigkeitsänderung in Phase P₄ zu erkennen.

Während sich die Phasengrenze zwischen flüssigem und festem Material hier dann in einem Bereich mit großen Durchmesser befindet und sich großflächig über den Durchmesser erstreckt, befindet sich die Phasengrenze vorher nur in einem verhältnismäßig dünnen Bereich des Vorimpflings. Insofern ist zunächst eine verhältnismäßig hohe Geschwindigkeit gewünscht, um den Übergang schnell voranzutreiben, während später eine verhältnismäßig geringe Geschwindigkeit gewünscht ist, um nicht zu viel Material aufzuschmelzen, was angesichts der großflächigen Phasengrenze Schwierigkeiten bei der möglichst optimalen Formung des Konus mit sich brächte.

Die Reduktion der Geschwindigkeit erfolgt dabei zu einem Zeitpunkt, zu dem sich der Polykristall 100 an der zuvor ermittelten Umschalte-Position h' befindet. In Figur 3e ist diese Umschalte-Position mit einem Abstand h' relativ zum fixen Bezugspunkt P_{B}, ähnlich wie bei der Position bzw. dem Abstand h in Figur 3a, dargestellt. Bei Erreichen dieses Abstands h' hat die charakteristische Stelle P_{S} damit einen gewünschten Abstand d' von dem Bezugspunkt P_{B}. Der Abstand d' definiert dabei einen möglichst idealen Abstand, bei dem möglichst genau die gewünschte Menge an Material des Polykristalls 100 bei der vorgegebenen Reduktion der Geschwindigkeit aufgeschmolzen wird, um den gewünschten konischen Abschnitt 135 zu bilden. Eine solche Reduzierung der Geschwindigkeit kann sehr einfach automatisiert werden, da keine Regelung nötig ist.

## Patentansprüche

1. Verfahren zum Ziehen eines Einkristalls (150) nach dem FZ-Verfahren, bei dem ein Polykristall (100) mittels einer elektromagnetischen Schmelzvorrichtung (300) aufgeschmolzen und anschließend wieder auskristallisiert wird,
wobei in einer ersten Phase (P₁) ein unteres Ende des Polykristalls (100) mittels der Schmelzvorrichtung (300) aufgeschmolzen wird,
wobei in einer zweiten Phase (P₂) ein einkristalliner Impfling (140) an das untere Ende des Polykristalls (100) angebracht und beginnend von einem oberen Ende des Impflings (140) an aufgeschmolzen wird
wobei in einer dritten Phase (P₃) zwischen einem unteren Abschnitt des Impflings (140) und dem Polykristall (100) ein Dünnhals-Abschnitt (130) gebildet wird, dessen Durchmesser (d_{D}) geringer als derjenige (d_{I}) des Impflings (140) ist, und
wobei in einer vierten Phase (P₄) zwischen dem Dünnhals-Abschnitt (130) und dem Polykristall (100) ein konischer Abschnitt (135) des Einkristalls gebildet wird,
**dadurch gekennzeichnet, dass** vor Erreichen der vierten Phase (P₄) eine Umschalte-Position (h') des Polykristalls (100), bei welcher eine Geschwindigkeit, mit welcher der Polykristall (100) relativ zur Schmelzvorrichtung (300) bewegt wird, betragsmäßig reduziert werden soll, ermittelt wird, wobei zur Ermittlung der Umschalte-Position (h')
a) ein Abstand (d) einer für den Polykristall charakteristischen Stelle (P_{S}), die sich am unteren Ende eines konischen Abschnitts (110) des Polykristalls (100) befindet, relativ zu einem fixen Bezugspunkt (P_{B}) gemessen wird, und wobei aus dem Abstand (d) die Umschalte-Position (h') ermittelt wird, oder
b) eine Zwischen-Position (h) des Polykristalls ermittelt wird, bei welcher eine für den Polykristall charakteristische Stelle (P_{S}), die sich am unteren Ende eines konischen Abschnitts (110) des Polykristalls (100) befindet, während einer Bewegung des Polykristalls (100) einen vorgegebenen Abstand (d) zu einem fixen Bezugspunkt (P_{B}) erreicht oder überschreitet, und wobei aus der Zwischen-Position (h) die Umschalte-Position (h') ermittelt wird, und
wobei in der vierten Phase (P₄) die Geschwindigkeit, mit welcher der Polykristall (100) relativ zur Schmelzvorrichtung (300) bewegt wird, bei Erreichen der Umschalte-Position (h') betragsmäßig reduziert wird.

2. Verfahren nach Anspruch 1, wobei aus dem Abstand (d) die Umschalte-Position (h') ermittelt wird, indem zusätzlich zu dem Abstand (d) eine Zwischen-Position (h) des Polykristalls (100) ermittelt wird, aus der unter Verwendung des Abstands (d) die Umschalte-Position (h') ermittelt wird.

3. Verfahren nach Anspruch 1 oder Anspruch 2, wobei die für den Polykristall (100) charakteristische Stelle (Ps) anhand eines charakteristischen oder vorbestimmten Durchmessers des Polykristalls (100) erfasst wird.

4. Verfahren nach einem der Ansprüche 1 bis 3, wobei die für den Polykristall (100) charakteristische Stelle (Ps) am unteren Ende des konischen Abschnitts (110) des Polykristalls (100) eine Stelle umfasst, an welcher sich ein Neigungswinkel des konischen Abschnitts des Polykristalls (100) um mehr als einen vorbestimmten Wert ändert.

5. Verfahren nach einem der Ansprüche 1 bis 4, wobei die für den Polykristall (100) charakteristische Stelle (Ps) unter Verwendung einer Kamera (351), die insbesondere oberhalb der Schmelzvorrichtung (300) angeordnet ist, erfasst wird.

6. Verfahren nach einem der vorstehenden Ansprüche, wobei die Umschalte-Position (h') in der ersten Phase (P₁) und/oder in der zweiten Phase (P₂) ermittelt wird.

7. Verfahren nach einem der vorstehenden Ansprüche, wobei die Geschwindigkeit, mit welcher der Polykristall (100) relativ zur Schmelzvorrichtung (300) bewegt wird, vor der Reduzierung 0,5 mm/min oder mehr, insbesondere zwischen 0,5 und 2 mm/min, und nach der Reduzierung weniger als 0,5 mm/min, insbesondere zwischen 0,1 und 0,5 mm/min, beträgt.

8. Verfahren nach einem der vorstehenden Ansprüche, wobei die Geschwindigkeit, mit welcher der Polykristall (100) relativ zur Schmelzvorrichtung (300) bewegt wird, vor und nach der Reduzierung der Geschwindigkeit entsprechend einer Soll-Kurve für die Geschwindigkeit bewegt wird.

## Claims

1. Method for pulling a single crystal (150) according to the FZ method, in which a polycrystal (100) is melted by means of an electromagnetic melting device (300) and subsequently recrystallized,
wherein in a first phase (P₁) a lower end of the polycrystal (100) is melted by means of the melting device (300),
wherein, in a second phase (P₂), a single-crystalline seedling (140) is attached to the lower end of the polycrystal (100) and melted starting from an upper end of the seedling (140)
wherein, in a third phase (P₃), a thin-neck portion (130) is formed between a lower portion of the seedling (140) and the polycrystal (100), the diameter (d_{D}) of which is smaller than that (d_{I}) of the seedling (140), and
wherein in a fourth phase (P₄) between the thin neck portion (130) and the polycrystal (100) a conical portion (135) of the single crystal is formed,
**characterized in that,** before reaching the fourth phase (P₄), a switching position (h') of the polycrystal (100) at which a speed at which the polycrystal (100) is moved relative to the melting device (300) is to be reduced in terms of amount, is determined, wherein to determine the switching position (h')
a) a distance (d) of a point (Ps) characteristic of the polycrystal, which is located at the lower end of a conical section (110) of the polycrystal (100), is measured relative to a fixed reference point (P_{B}), and wherein the switching position (h') is determined from the distance (d), or
b) an intermediate position (h) of the polycrystal is determined, at which a point (Ps) characteristic of the polycrystal, which is located at the lower end of a conical section (110) of the polycrystal (100), reaches or exceeds a predetermined distance (d) from a fixed reference point (P_{B}) during a movement of the polycrystal (100), and wherein the switching position (h') is determined from the intermediate position (h), and
wherein in the fourth phase (P₄), the speed with which the polycrystal (100) is moved relative to the melting device (300) is reduced in terms of amount when the switching position (h') is reached.

2. Method according to claim 1, wherein the switching position (h') is determined from the distance (d) by determining, in addition to the distance (d), an intermediate position (h) of the polycrystal (100) from which the switching position (h') is determined using the distance (d).

3. Method according to claim 1 or claim 2, wherein the characteristic point (Ps) of the polycrystal (100) is detected on the basis of a characteristic or predetermined diameter of the polycrystal (100).

4. Method according to any one of claims 1 to 3, wherein the position (Ps) characteristic of the polycrystal (100) at the lower end of the conical portion (110) of the polycrystal (100) comprises a position at which an angle of inclination of the conical portion of the polycrystal (100) changes by more than a predetermined value.

5. Method according to one of claims 1 to 4, wherein the point (Ps) characteristic of the polycrystal (100) is detected using a camera (351) which is arranged in particular above the melting device (300).

6. Method according to one of the above claims, wherein the switching position (h') is determined in the first phase (P₁) and/or in the second phase (P₂).

7. Method according to any of the above claims, wherein the speed at which the polycrystal (100) is moved relative to the melting apparatus (300) is 0.5 mm/min or more, in particular between 0.5 and 2 mm/min, before reduction and less than 0.5 mm/min, in particular between 0.1 and 0.5 mm/min, after reduction.

8. Method according to any of the foregoing claims, wherein the speed at which the polycrystal (100) is moved relative to the melting apparatus (300) is moved before and after reduction of the speed according to a desired curve for the speed.

## Revendications

1. Méthode de tirage d'un monocristal (150) selon la méthode FZ, dans laquelle un polycristal (100) est fondu au moyen d'un dispositif de fusion électromagnétique (300) et ensuite recristallisé,
dans laquelle, dans une première phase (P₁), une extrémité inférieure du polycristal (100) est fondue au moyen du dispositif de fusion (300),
dans laquelle, dans une deuxième phase (P₂), un plant monocristallin (140) est fixé à l'extrémité inférieure du polycristal (100) et fondu à partir d'une extrémité supérieure du plant (140)
dans laquelle, dans une troisième phase (P₃), une partie à col mince (130) est formée entre une partie inférieure du plant (140) et le polycristal (100), dont le diamètre (d_{D}) est inférieur à celui (d_{I}) du plant (140), et
dans laquelle, dans une quatrième phase (P₄), entre la partie de col mince (130) et le polycristal (100), une partie conique (135) du monocristal est formée,
**caractérisé en ce que,** avant d'atteindre la quatrième phase (P₄), une position de commutation (h') du polycristal (100) à laquelle une vitesse à laquelle le polycristal (100) est déplacé par rapport au dispositif de fusion (300) doit être réduite en termes de quantité, est déterminée, dans laquelle pour déterminer la position de commutation (h')
a) une distance (d) d'un point (Ps) caractéristique du polycristal, qui est situé à l'extrémité inférieure d'une section conique (110) du polycristal (100), est mesurée par rapport à un point de référence fixe (P_{B}), et dans lequel la position de commutation (h') est déterminée à partir de la distance (d), ou
b) une position intermédiaire (h) du polycristal est déterminée, à laquelle un point (P_{S})
caractéristique du polycristal, qui est situé à l'extrémité inférieure d'une section conique (110) du polycristal (100), atteint ou dépasse une distance prédéterminée (d) d'un point de référence fixe (P_{B}) pendant un mouvement du polycristal (100), et dans lequel la position de commutation (h') est déterminée à partir de la position intermédiaire (h), et dans laquelle, dans la quatrième phase (P₄), la vitesse à laquelle le polycristal (100) est déplacé par rapport au dispositif de fusion (300) est réduite en termes de quantité lorsque la position de commutation (h') est atteinte.

2. Procédé selon la revendication 1, dans lequel la position de commutation (h') est déterminée à partir de la distance (d) en déterminant, en plus de la distance (d), une position intermédiaire (h) du polycristal (100) à partir de laquelle la position de commutation (h') est déterminée en utilisant la distance (d).

3. Procédé selon la revendication 1 ou la revendication 2, dans lequel le point caractéristique (P_{S}) du polycristal (100) est détecté sur la base d'une caractéristique ou d'un diamètre prédéterminé du polycristal (100).

4. Procédé selon l'une quelconque des revendications 1 à 3, dans lequel la position (P_{S}) caractéristique du polycristal (100) à l'extrémité inférieure de la partie conique (110) du polycristal (100) comprend une position à laquelle un angle d'inclinaison de la partie conique du polycristal (100) change de plus d'une valeur prédéterminée.

5. Procédé selon l'une des revendications 1 à 4, dans lequel le point (P_{S}) caractéristique du polycristal (100) est détecté à l'aide d'une caméra (351) qui est disposée en particulier au-dessus du dispositif de fusion (300).

6. Procédé selon l'une des revendications ci-dessus, dans laquelle la position de changement (h') est déterminée dans la première phase (P₁) et/ou dans la deuxième phase (P₂).

7. Procédé selon l'une des revendications ci-dessus, dans lequel la vitesse à laquelle le polycristal (100) est déplacé par rapport à l'appareil de fusion (300) est de 0,5 mm/min ou plus, en particulier entre 0,5 et 2 mm/min, avant réduction et inférieure à 0,5 mm/min, en particulier entre 0,1 et 0,5 mm/min, après réduction.

8. Procédé selon l'une des revendications précédentes, dans laquelle la vitesse à laquelle le polycristal (100) est déplacé par rapport à l'appareil de fusion (300) est déplacée avant et après réduction de la vitesse selon une courbe souhaitée pour la vitesse.
